Europäisches Patentamt

European Patent Office

Office européen des brevets

(11) Publication number: **0 218 119**
**A2**

# EUROPEAN PATENT APPLICATION

(21) Application number: **86112662.1**

(22) Date of filing: **12.09.86**

(51) Int. Cl.4: **H01L 39/16**

(30) Priority: **11.10.85 US 786788**

(43) Date of publication of application:
**15.04.87 Bulletin 87/16**

(84) Designated Contracting States:
**DE FR GB**

(71) Applicant: **International Business Machines Corporation**
**Old Orchard Road**
**Armonk, N.Y. 10504(US)**

(72) Inventor: **Gallagher, William Joseph**
**577 Ashford Avenue**
**Ardsley New York 10502(US)**
Inventor: **Raider, Stanley Irwin**
**350 South State Road**
**Briarcliff Manor New York 10510(US)**

(74) Representative: **Burt, Roger James, Dr.**
**IBM United Kingdom Limited Intellectual**
**Property Department Hursley Park**
**Winchester Hampshire SO21 2JN(GB)**

(54) Superconductor switching device.

(57) A switch is provided that introduces quasiparticles at an asymmetric location into a reduced cross-sectional area microbridge link (4) that is part of an output path. The quasiparticles nucleate a small region of normal resistivity and the normal region propagates to produce normal resistivity in the entire reduced cross-sectional area microbridge link (4). The asymmetry of the location provides input-output isolation. The high critical current, high resistivity material for the reduced cross-section member (4) provides high current and voltage gain and the small size provides high speed. In one structure, an input film conductor (5) is asymmetrically, centrally positioned in an insulator stack, and a microbridge link (4) is positioned on a bevelled side of the stack with the input conductor (5) in tunnelling relationship with part of the narrow portion of the microbridge link (4). Decoupling between input and output sufficient to permit one switch to drive several others is provided. Voltage gain can be sufficient to serve as an interface between superconducting devices and semiconductor circuitry.

# FIG. 4

## SUPERCONDUCTOR SWITCHING DEVICE

The present invention relates to superconductor switching devices.

The development of electronic integrated apparatus has been driven by two main desires, the achievement of greater speed and the building of the functions achieved in a smaller size. Semiconductor technology has brought both great speeds and very high compactness in integrated circuitry. The superconducting electronics field has long been known as having great speed and compactness potential but manufacture has been difficult.

The semiconductor and superconductor fields have some features in common. As the semiconductor field is developing, the lower temperatures required for superconductivity are also useful in some semiconductor materials for increasing carrier mobility. Thus, a trend is appearing in the art in which advantages in both types of technology are beginning to outweigh items previously considered to be disadvantages and a switching structure that would combine the two technologies would be very useful.

There have been two cryogenic superconducting injection controlled switches developed that achieve gain through the switching of a large current in response to a smaller signal or control current.

One type is described in Physical Review Letters, Vol 37, No 3, 1976, p 150 and J. Appl. Phys. 51 (3), 1982, 1980, where an injected control current is symmetrically introduced into a narrow region between two wider regions constructed to exhibit nonlinear superconducting properties in response to the injected current. This device is known in the superconducting art as a controllable weak link where the injected current drives the link out of superconductivity.

A second illustration of this type of device is described in the Japanese Journal of Applied Physics 21, Supplement 21-1, 331, 1982 in which a device known as a microbridge; this is a structure where two wide superconducting regions are joined by a narrow superconducting region that exhibits different superconducting threshold response from the wider regions. The structure is controlled by an injection current at high voltage through an opening in an insulator to a silicon substrate. The injection current is into the entire microbridge and the nearby wide regions.

The second type of device is described in US-A-4,334,158 and is known in the art as the "QUITERON" device which is an acronym, the first four letters of which stand for Quasiparticle Injection Tunnelling. This device is a three-terminal switch in which two superimposed junctions share a common electrode.

Figures 1A, 1B, 1C and 1D, Figure 2 and Figure 3 are each illustrations of the three prior art devices;

Figure 4 is a top view of a schematic of one embodiment of the invention;

Figure 5 is a side view taken along the line 5-5 of Figure 4;

Figure 6 is a perspective view of another embodiment of the invention;

Figure 7 is a side view of Figure 6 taken along the 7-7;

Figure 8 is a schematic illustration of circuit connections to demonstrate the current performance of the invention;

Figures 9, 10 and 11 are electrical operating characteristics of the invention;

Figures 12A to 12H are plan and side views of the steps involved in the manufacture of the embodiment of the invention illustrated in Figure 4; and

Figures 13A to 13D are illustrations of the partial product formed at steps of manufacture of the embodiment of the invention in Figure 6.

The invention is a switching principle in which a large difference between critical supercurrent and critical quasiparticle injection current is employed together with hot spot nucleation and subsequent propagation. The invention may be considered as operating by injecting a small quasiparticle current into a localised spot in a superconductive thin and narrow cross-sectional area member which causes that spot to become resistive and the heat at that resistive spot in turn causes the entire superconductive small cross-sectional area member to become resistive. The extent of the normal region is confined to the small cross section region by thick and wide contact electrodes.

The switching principle provides voltage gain and decoupling between input and output.

The invention provides these advantages in a variable thickness microbridge link type structure with an asymmetrically positioned input electrode wherein combined horizontal and vertical differentiation manufacturing steps are employed to achieve simplicity.

The advantages and importance of the switching principles and features of the invention can best be understood from the following description in detail of the prior art structures.

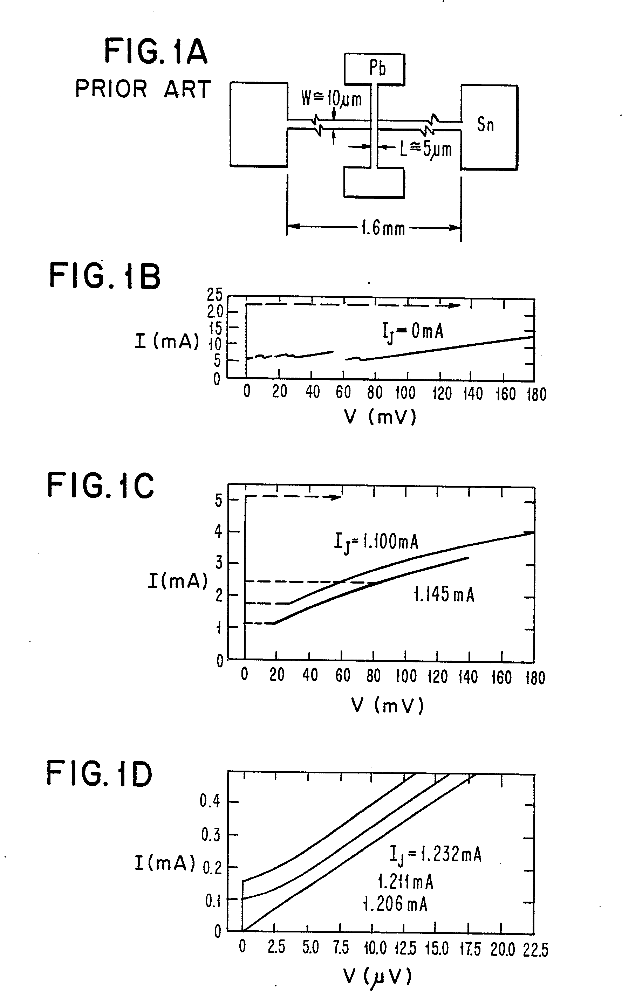

In Figures 1A, 1B, 1C and 1D, there is shown the structure and operating characteristics of the weak link type structure described in Phys. Rev. Lett. 37, 150 (1976) and in J. Appl. Phys. 51, 1682 (1980).

Referring to Figure 1A, the quasiparticle injection weak link configuration is illustrated. In this configuration, quasiparticles which are electronic excitations or phonons that perturb superconductivity are injected from the Pb-5 micrometer line into the Sn-10 micrometer weak link line which is driven non-superconductive in response to the injected quasiparticle current. The performance is illustrated in the graphs of Figures 1B, 1C and 1D.

Referring to Figure 1B, the operating characteristics of the Sn line is shown with no injection from the Pb line. There is a superconductive branch at zero voltage from zero current to a maximum supercurrent of 23 milliamperes, and a resistive branch at non-zero voltages.

Referring to Figure 1C, the Sn line operating characteristic with modest injection shows a much reduced maximum supercurrent in the zero voltage branch.

Referring next to Figure 1D the Sn line characteristic is shown when the injection is just sufficient to drive it into a non-latching superconductive region where there is only a single branch in the characteristic.

The structure of Figure 1 as may be seen from the operating characteristics employs a quasiparticle current to switch a narrow superconductive wire from superconductivity to resistivity. To develop a large output voltage the superconductive wire, the Sn line, must be long and a large link driven normal. The growth of the normal region is a slow process, and IR voltage drop on the normal line results in a strong modification of the control electrode voltage.

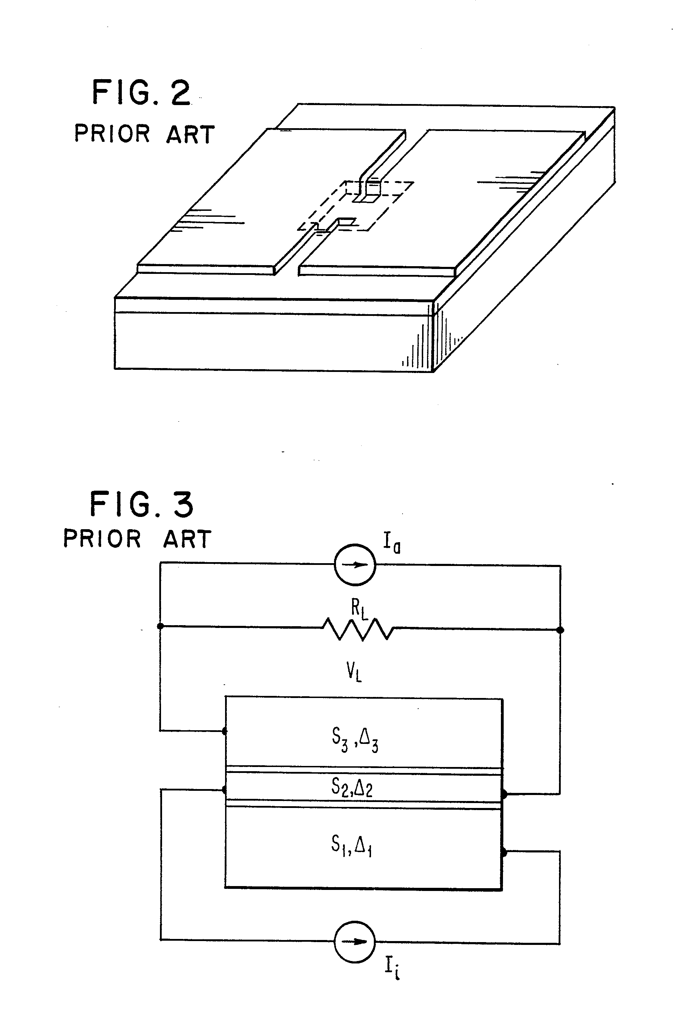

The second example of the first type of prior art structure is that shown in Figure 2.

Here is depicted a controlled microbridge type of structure as described in the Japanese Journal of Applied Physics 21, Supplement 21-1, 331, 1982. In this structure, a narrow microbridge is formed in a substrate by injection through an opening under the conductor exposing the silicon substrate. An external stimulus, a quasi-particle current introduced through the opening that exposes the substrate operates to change the superconducting threshold response of the conductor. This device requires a large input voltage to pass the quasiparticle current from the substrate to the superconductor. The output is in the 1-2 millivolt regime where the superconducting transition phenomenum occurs. With this device, the high input voltage combined with the high output voltage means there is no voltage gain and in fact there is a substantial voltage loss.

Referring next to Figure 3, the structure of US-A-4,334,158 is quite different from the other two in the prior art in that a shared electrode has its performance in one circuit, the output circuit, altered by quasiparticle injection from another circuit, the input circuit. This structure might be considered to be of the type of the "weak link" type of Figure 1 with the variation that in US-A-4,334,158 the "weak links" in essence are superimposed junctions. In the structure of US-A-4,334,158, however, it is the common shared electrode that is driven out of equilibrium and not either of the weak links as in the other prior art.

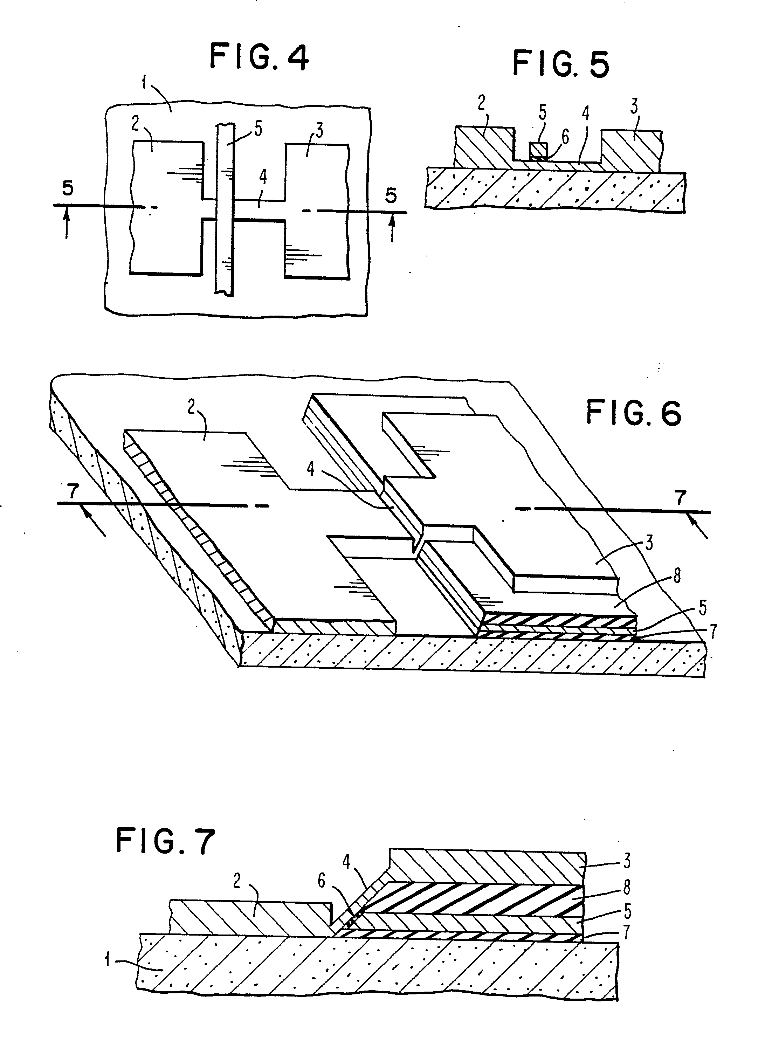

Referring next to Figures 4 through 7, a description of two embodiments of the invention is provided.

Referring to Figure 4, a plan or top view of one embodiment is shown wherein on a substrate 1, there is positioned two large cross-section areas 2 and 3, separated by an element 4 of reduced cross-sectional area and special properties. The element 4 performs as a variable thickness microbridge, that is, it exhibits nonlinear superconducting properties in response to injected current and it also is a link or conductor that has the special properties of high critical current density to exhibit superconductivity and high normal resistivity. For one embodiment, the required high critical supercurrent density is greater than 500,000 amps per sq cm to be driven out of the superconductive state. The corresponding high normal state resistivity is of the order of 100 micro ohm centimetres or greater. The element 4 with the special properties in accordance with the invention is described herein as a variable thickness microbridge link which may be referred to hereinafter as a microbridge link. The prior art devices did not employ variable thickness microbridges.

The term microbridge or weak link is often used generically for a weak superconductive connection between two massive superconductive regions, the connection exhibiting Josephson effects. The microbridge links of the present invention are what might properly be called "strong links" and do not generally display Josephson properties, except over a very small range of temperature and electrical bias, and Josephson effects are not involved in the operation of the present invention.

Asymmetrically positioned across the microbridge link 4 closer to larger cross-sectional area 2 than 3 but insulated from microbridge link 4 is a control electrode 5.

Further details of the structure of Figure 4 is shown in Figure 5 which is a side view taken along the line 5-5 of Figure 4. In Figure 5, on the substrate 1 between the large cross-sectional regions 2 and 3 there is the reduced cross-sectional element, the microbridge link 4. The control electrode 5 is separated from the microbridge link element 4 by an insulating member 6. The insulator 6 is of the type similar to a Josephson barrier or tunnelling barrier member wherein quasiparticle injection occurs above a specific threshold.

In operation a quasiparticle current is injected from control element 5 through insulator 6 into microbridge link 4. The element 4 performs as a "strong link" in that it strongly joins two broad cross section superconductive regions 2 and 3, it is small in cross section and it exhibits different superconducting threshold response than the larger cross section regions 2 and 3 but the microbridge 4 has additional requirements in that the special properties of high critical supercurrent density when superconductivity is present and when the element 4 is resistive it has a high normal resistivity. The microbridge link 4, because of its properties, is sensitive to a small quasiparticle current injected from 5 through 6 into 4 and becomes resistive at the spot of injection. That spot in turn being resistive becomes heated by what was the supercurrent but has now become normal current. The heating is enhanced by the high normal resistivity special property of element 4, and the spot rapidly propagates and switches the entire microbridge link 4 resistive. The asymmetric positioning of control element 5 with respect to the location of larger areas 2 and 3 provide voltage gain and input-output decoupling. The asymmetry element is not suggested in the prior art and is essential to obtaining these desirable electrical properties.

Another embodiment of the invention is illustrated in connection with Figures 6 and 7 wherein like reference numerals are employed. On a substrate 1, broad cross-sectional regions 2 and 3 are joined by the microbridge link region 4 positioned on the bevelled portion of a vertical stack of an insulating layer on both sides of a conducting control layer. The control element 5 is asymmetrically positioned.

The structure is shown from a side view in Figure 7 taken along the line 7-7 of Figure 6. On the substrate 1 the regions of broad cross-sectional area 2 and 3 are joined by the microbridge link 4 which is on the bevelled edge of a stack of horizontal layers 7, 5 and 8 where the layer 5 is the control electrode and is asymmetrically positioned with respect to the length of element 4 by the fact that the insulating layer 7 is thinner than that of the insulating layer 8 and the control electrode insulating layer 6 separates elements 5 and 4.

In operation, referring to Figure 7, quasiparticles are introduced from the control electrode 5 through the insulator 6 into the superconducting microbridge link 4. The quasiparticle current produces a condition in which the superconductivity in the microbridge link 4 at the point of injection is disturbed and a localised hot spot occurs in the microbridge link 4 at the point of injection. The hot spot once nucleated propagates and drives the entire microbridge link 4 resistive. The special property requirements in the microbridge link that there be a high critical supercurrent density and high normal state resistivity assist in the propagation. The requirement that there be a high normal resistivity also provides the large voltage gain. The high resistivity provides the ability to drive other devices and allows the length of the link 4 to be small so the hot spot propagation is very rapid.

In comparing the embodiments of Figures 4 and 5 and of Figures 6 and 7, major advantages of the invention over the prior art are that (1) both lateral and thickness control are used to establish structurally the asymmetric location of the hot spot nucleation needed for isolation and (2) the large supercurrent density and the high resistivity provide for small devices and high speed response and a large voltage output, yet high current gain is retained.

In comparing the invention with previous switches, the structure of the invention has no shared electrode as in US-A-4,334,158. Further, the asymmetry of control electrode placement which is provided and facilitated by variable lateral and thickness geometries which provide advantages not available in other microbridge and weak link structures known in the art.

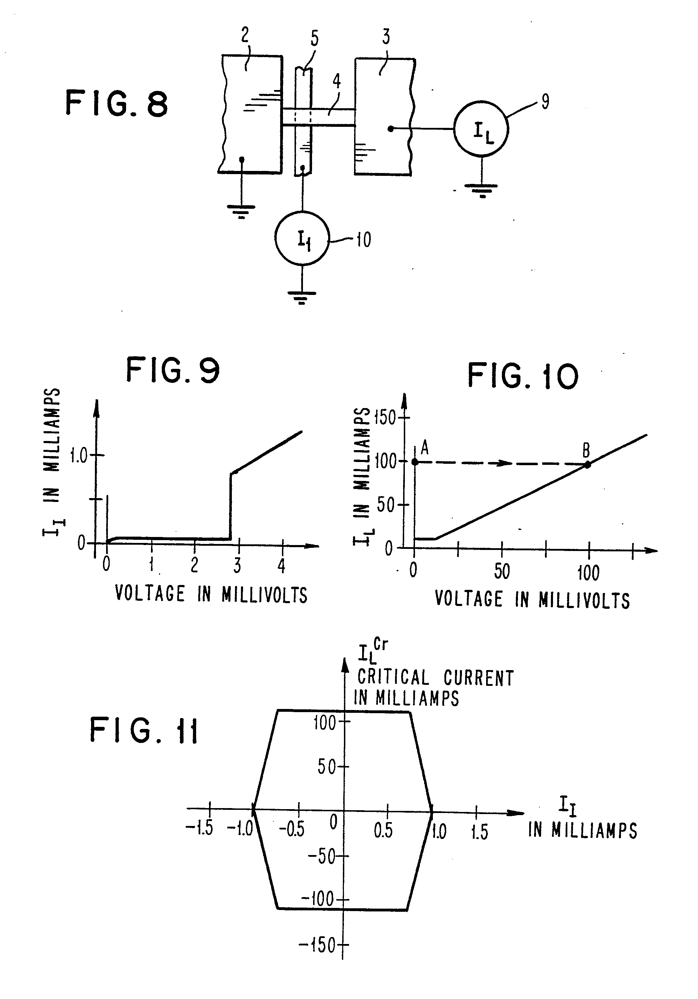

The circuit performance operation of the device of the invention is illustrated in the combination of Figures 8 to 11. In Figure 8 a schematic of the invention with load and biasing current sources is illustrated. In Figures 9, 10 and 11 the operating characteristics are graphically shown.

Referring to Figure 8 wherein like reference numerals with respect to Figures 4-7 are employed, in the output circuit, element 2 is connected to ground and element 3 is connected to ground through a current generator element 9, labelled $I_L$, which provides a current through the microbridge link 4. The current $I_L$ is chosen to be close to but less than the deliberately selected high critical supercurrent of the microbridge link 4. Through control electrode 5 into the microbridge link 4, an injection current generator element 10 provides a quasiparticle injection current labelled $I_i$. As the quasiparticle injection current $I_i$ is increased, the critical supercurrent value is reduced. The microbridge link 4, in accordance with the invention, has been constructed to have much stronger sensitivity to quasiparticle injection current $I_i$ than to supercurrent $I_L$, so that a small value of $I_i$ can make big changes in the microbridge link 4 critical supercurrent. When the current $I_i$ reaches the critical quasiparticle injection current, the microbridge link spot under the control electrode 5 becomes resistive. The additional dissipation caused by the Joule heating due to the current $I_L$ being in the resistive region at this location will cause the resistive region to spread, ultimately propagating until the entire microbridge link 4 is in the resistive state. In doing so, a substantial voltage will appear across the microbridge link 4 and by virtue of the asymmetric positioning of the control electrode and the vertical geometry for that positioning, the large voltage that develops in the output has only a small effect on the input voltage. The size of this generally undesirable effect on the input can be made arbitrarily small by increasing the device asymmetry.

The injector characteristics are illustrated graphically in connection with Figure 9. The microbridge link output performance is further graphically illustrated in Figure 10 wherein an operating point shown as A prior to the quasiparticle injection will shift abruptly to point B, generating a substantial voltage when the microbridge link 4 becomes resistive.

The switching principle of the invention has latching properties. When $I_i$ quasiparticle injection current applied through control electrode 5 into the microbridge link 4 is switched off, the dissipation in the microbridge link 4 is sufficient to keep the microbridge link 4 in the resistive state. The microbridge link 4 current $I_L$ must be turned off in order for the microbridge link 4 to return to the normal state. The device thus latches in the resistive state. Further, since superconducting devices are sensitive to temperature, the latching is also controllable by temperature. Because the critical current for quasiparticle injection is substantially less than the critical supercurrent of the microbridge link 4, there will be substantially more current that can be diverted out of the output path made up of elements 2, through microbridge link 4 to 3 into a resistive load than is required to initiate the switching. The device of the invention has substantial current gain. Supercurrents in excess of 100 milliamps can be switched for example with 1 milliampere of quasiparticle injection current.

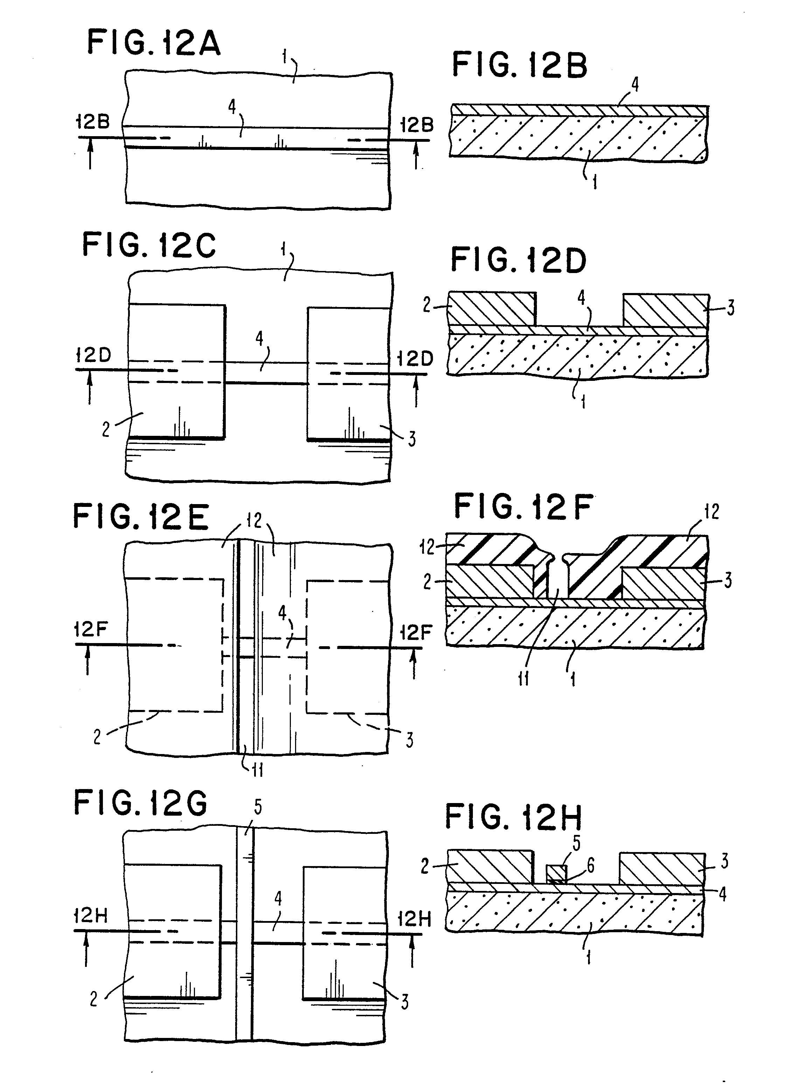

Referring next to Figure 11, a threshold curve is illustrated for the switching performance of the microbridge link 4 from the superconducting state to the normal state illustrating the high current gain. The Josephson or quantum mechanical tunneling insulator 6 is fabricated to have a voltage sensitive barrier such that a voltage is required that is just beyond the current step at about 2.7 millivolts in Figure 9, for example, while enough quasiparticle current is being supplied to drive the region of the microbridge link adjacent to it into the resistive state by the quasiparticle injection.

Under these circumstances, the control electrode 5 injection voltage would be approximately 3-5 millivolts whereas the output voltage, which is proportional to the normal state resistivity and the length of the microbridge link, can be made arbitrarily large. Outputs as large as 100 millivolts are achieved. The voltage gain as well as the current gain can therefore be large. In practice, only a modest voltage gain would be needed in most situations and shorter, high resistivity devices may be designed so that the response time would be faster.

The location of control element 5 asymmetrically closer to the region 2 than the region 3 is so that only a small voltage drop appears between the grounded electrode 2 in Figure 8 and the base electrode 5 of the injector junction made up of layers 4, 6 and 5. It is desirable to keep such a voltage drop as small as possible in order that the quasiparticle current injected into the microbridge link 4 is as little disturbed as possible by the large voltage that develops across the link. In this manner, good isolation of the output from the input will be achieved.

The turn-on and turn-off speeds of the propagating hot spot in the microbridge 4 are strong functions of device size of the microbridge link 4, with smaller size of the microbridge link 4, with smaller sizes having much faster responses. Devices of the basic geometry shown in Figures 4-7, but with minimum lateral feature sizes of a few tenths of a micron exhibit response times of the order of tens of picoseconds. Such switching speeds make the device suitable for high performance logic and memory circuit applications with the significant advantages of higher gain and smaller size.

Non-latching performance is also possible. In small well-cooled microbridge links the cooling might be sufficient so that when the injection is removed, the link will instead return to a superconducting state and the device will thus not latch up.

In general, the fabrication of planar devices as the embodiment of the invention in Figures 4 and 5 with lateral feature sizes and alignment tolerances of the order of 0.1 micron are feasible with advanced lithography. In the embodiment of the invention Figures 6 and 7, the submicron feature sizes and submicron alignments are achieved without any demanding submicron lithography. In these structures, the injection insulator 6 is an edge junction formed on the edge of the control electrode 5 sandwiched in an insulator control element insulator trilayer 7, 5 and 8. The microbridge link 4 covers the trilayer edge, with the larger electrode portions 2 and 3 of the variable thickness bridge being above and below the edge on which the link is located. The structure of Figures 6 and 7 may be fabricated by a sequence of steps such that the injection insulator 6 at the end of the control member 5 is self-aligned along the microbridge link 4 on the 7, 8, 5 film edge and the broad area banks 2 and 3 are self-aligned above and below the link on the edge. The spacing in this structure is determined by film thicknesses which can be very well controlled.

Referring to Figures 12A-12H, an illustration is provided of the steps involved in the fabrication of the device of Figures 4 and 5. In Figures 12A in a first step, the microbridge link 4 is deposited through a resist pattern for width and duration for thickness, on a suitable substrate 1. A side view along the line AA is shown in Figure 12B. For an example, the substrate 1 may be of $Al_2O_3$ and the deposit of the microbridge link material 4 would be of NbN which has the special properties of high critical supercurrent threshold density and high normal resistivity when deposited by the technique of reactive sputtering.

Referring next to Figure 12C, the broad area regions 2 and 3 are simultaneously deposited on the ends of the microbridge link 4 using standard techniques of photoresist, patterning, depositing and etching or lift-off. A side view of Figure 12C is shown in Figure 12D.

Referring next to Figures 12E and 12F, the location for positioning of the control electrode 5 and insulator 6 is provided. In Figure 12E the substrate and conductors fabricated thus far are coated with photoresist and a lift-off stencil is patterned with an opening 11 for the control electrode 5 and insulator 6. The lift-off resist shown as 12, has a narrow opening 11 for deposition of the insulator 6 and control electrode 5.

Referring next to Figures 12G and 12H, the top and side view are provided of the completed device of Figures 4 and 5 formed with the control electrode 5 present. The insulator 6 is formed on the opening of the photoresist 12 in Figure 12F by oxidizing the exposed microbridge link region 11 before deposition of the control electrode 5. The coated stencil 12 is removed, leaving the completed structure.

It will be apparent to one skilled in the art, that each of the steps employed are well known and individually all involve commonly practiced procedures. It would further be apparent to one skilled in the art in the light of the principles set forth that alternative processes may be substituted for the individual steps.

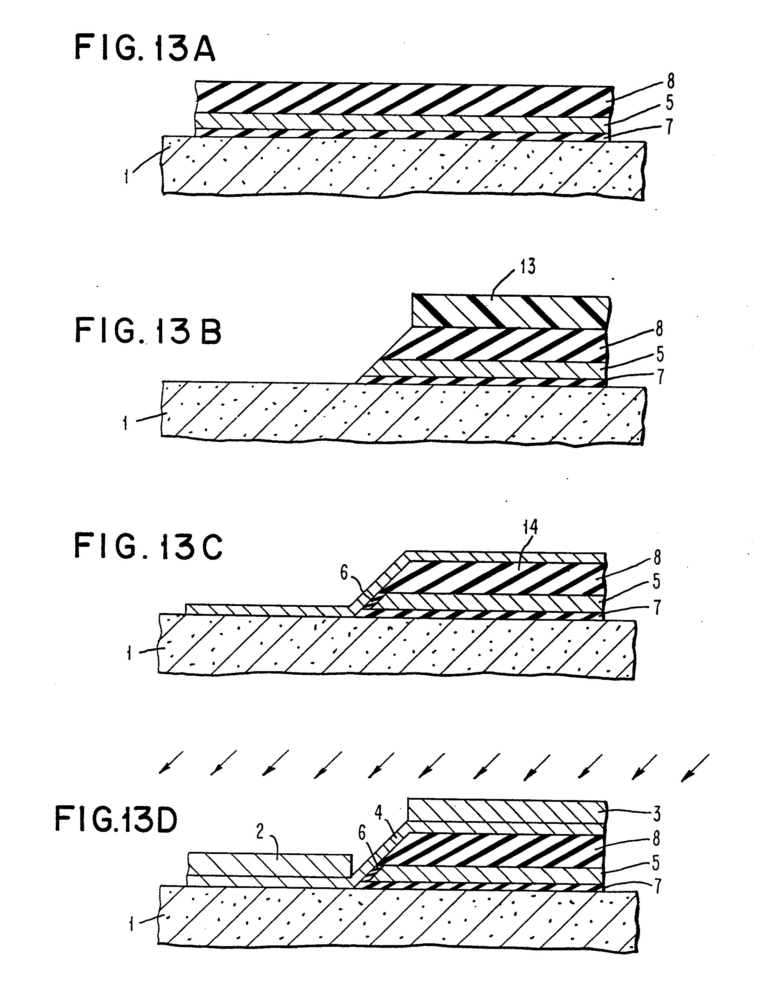

Referring next to Figures 13A-13D, a fabrication approach is provided for the structure of Figures 6 and 7. In the structure of Figure 6, the features of size of the order of 0.1 micrometer are self-aligned and readily achieved using conventional optical lithography.

Referring to Figure 13A, a blanket depositing series of steps is employed for the trilayer 7, 5, 8 insulator-superconductor-insulator sandwich on a suitable substrate 1. This is accomplished by the deposition of a film of for example Nb anodizing it to completion, depositing a second Nb film on top of the anodized layer, and partially anodize this top Nb film, leaving a $Nb_2O_5$-$Nb$-$Nb_2O_5$ trilayer with different oxide thickness produced by the anodizations.

Referring to Figure 13B, the trilayer assembly is coated with photoresist, the photoresist is patterned and plasma etched into the underlying trilayer film. A well known $CF_4$-$O_2$ plasma etch process will produce the 45 degree angular edge face 13 in the trilayer. Alternatively, a sputter trilayer could be similarly patterned using an ion milling process and producing the angular face 13.

Referring to Figure 13C, the etching stencil is then stripped and the trilayer is again coated with photoresist and a lift-off stencil for the link material is formed. The exposed control element edge 5 in the trilayer is oxidized to form the insulating barrier 6, for example $Nb_2O_5$ on an Nb control element 5 edge and the microbridge link 4 material 14, for example NbN, is deposited. The coated stencil is then removed leaving the structure illustrated in Figure 13C.

Referring next to Figure 13D, the broad area regions corresponding to element 2 and 3 of, for example, Nb are then deposited by a shadow evaporation shown by an angle which is slightly greater than the angular edge face 13 so that the broad area regions 2 and 3 are built up more rapidly on the horizontal than over the diagonal edge face 13 where the link would go. This produced broad area regions or banks 2 and 3 that are self-aligned to the microbridge link 4 and with the insulator 6. A resist stencil and an etching process can be used to pattern this layer where it need not be critically aligned.

Referring to Figures 4 and 5, in a preferred embodiment of the present invention, the substrate 1 would be $Al_2O_3$, the microbridge link 4 would be for example Nb and the broad area regions 2 and 3 would be Nb. The length of the microbridge 4 would be 2-4 microns wide, 1500 Angstroms thick and 10-40 microns in length. The insulator 6 would be of Nb oxide at a thickness of the order of 15 Angstroms. The thickness would provide a tunneling threshold of 0.1 volt. The Nb material has the properties of high critical current density for superconductivity and high normal resistivity.

The performance of the device of Figure 4 would be the gain bandwidth product governed by the speed of propagation of the hot spots. For this, the solution of the heat equation, Equation 1, is required.

$$\text{Equation 1:} \quad C\,\frac{dT}{dt} - K_n\,\frac{d^2T}{dx^2} + \frac{\alpha}{d}\,(T-T_B) = \left(\frac{I}{Wd}\right)^2 \rho\,\Theta(x_0(t) - x)$$

where

C = specific heat

$K_n$ = thermal conductivity in superconductor and normal metal

$\alpha$ = heat transfer coefficient out of film laterally

d = film thickness

$T_b$ = bath temperature

I = current $\rho$ = resistivity

W = film width

$x_0(t)$ = location of spot where $T = T_c$

(separates dissipative region from superconducting region)

Assuming a solution of the form $T(x,t) = T(x-vt) = T(z)$, where v is the velocity of hot spot propagation, and applying the boundary conditions in Equation 2.

$$\text{Equation 2:} \quad T(-\infty) = T_b + \frac{d}{\alpha}\left(\frac{I}{Wd}\right)^2 \rho \equiv T_h$$

Equation 3: $T(\infty) = T_b$

Equation 4: T continuous across region where dissipation starts (x -vt = 0)

$$\text{Equation 5:} \quad K\,\frac{dT}{dz}\bigg|_{z=0^-} = K\,\frac{dt}{dz}\bigg|_{z=0^+}$$

Equation 6: $T(z=0) = T_c$

The result is

$$\text{Equation 7:} \quad v = \frac{1}{C}\sqrt{\frac{\alpha K_n}{d}\sqrt{\frac{T_h + T_b - 2T_c}{(T_c - T_b)(T_h - T_c)}}}$$

so that the rate of voltage change is

$$\text{Equation 8:} \quad \frac{dV}{dt} = I\,\frac{\rho}{Wd}\,v$$

and the "rise" time $t_{rise}$ for a microbridge link of length L and output voltage $\Delta V = IL\rho/Wd$

$$\text{Equation 9:} \quad t_{rise} = \frac{\Delta V}{dV/dt} = LC \sqrt{\frac{d}{aK_n}} \frac{T_h - T_b - 2T_c}{\sqrt{(T_c - T_b)(T_h - T_c)}}$$

The turn off time, $t_{fall}$, can be as follows in Equation 10.

$$\text{Equation 10:} \quad t_{fall} = \frac{Cd(T_h - T_c)}{\alpha(T_h - T_b)}$$

In a preferred structure of Nb with $T_c = 9.2°K$, $C = 7.1 \times 10^{-3}$ J/cm$^3$-K with an assumed microbridge 4 link critical current density of $10^7$ A/cm$^2$, $\rho = 100\mu\Omega$-cm, $\alpha = 30$ W/cm$^2$-K and with the microbridge link dimensions of thickness = 50Å, width = 0.5$\mu$, and length = 1.5$\mu$. Then $t_{rise}$ would be 160 picoseconds and $t_{fall}$ would be 115 picoseconds.

This structure can be made with much smaller lateral dimensions than the example given with respect to Figures 4 and 5, and in turn correspondingly much higher device speeds.

Referring next to Figures 6 and 7, which is preferred, the microbridge link would be chosen of NbN which is a material having a large supercurrent in the superconducting state and a highly resistive in the normal state. The trilayer combination of 7, 5 and 8 would be 0.05 micron thick Nb$_2$O$_5$, 0.05 micron thick Nb, 0.1 micron thick Nb$_2$O$_5$, which can be plasma etched. The insulator 6 would be of Nb$_2$O$_5$ about 15Å thick.

In performance, considering the microbridge link to be a 50 Angstrom or greater thick NbN film, 2 microns wide, 0.20 microns long, a critical supercurrent density of $10^7$ A/cm$^2$ and a resistivity of 200 microohm-cm. Under these circumstances, the microbridge link would then have a resistance of 20 ohms. Such an output resistance would drive a 5-10 ohm superconducting transmission line. The critical supercurrent for such dimensions would be 4mA. When the microbridge link switches into the normal state, most of the current is transferred into the load as output current. For example, 3.2 mA would be transferred into a 5 ohm transmission line load. The output voltage across the 5 ohm load of the transmission line would then be 16 mV.

For the device, the input quasiparticle current required to drive the microbridge link 4 into the normal state is needed. For quasiparticle injection to drive the microbridge link 4 into the normal state, it is necessary for a normalised quasiparticle density, $Nqp/4N(0) \Delta_0$ of 0.4 to be built up. (N(O) is the single spin density of states at the Fermi level; $\Delta_0$ is the zero temperature superconducting energy gap.) The quasiparticle density that is built up is determined by a balance of the injection rate by tunnelling, Iqp, and the removal time, $\tau^*$, according to the expression in Equation 11.

Equation 11: $N_{qp} = I_{qp} \tau^*/eV$

where V is the bridge volume. Thus we get

Equation 12: $I_{qp} = 1.6eV\, N(0)\, \Delta_0/\tau^*$

for the injection quasiparticle current necessary to drive the microbridge link 4 normal. The quasiparticle removal from the microbridge link 4 is by recombination or by diffusion into the large area or bank regions 2 and 3. The intrinsic recombination time for NbN has never been measured or calculated, but is expected to be less than 20 ps. Phonon trapping would make the time longer. In the variable thickness bridge geometry, however, diffusion out to the bank regions would be expected to be the dominant quasiparticle removal mechanism. This time can be estimated as

Equation 13:
$$\tau_D = \frac{L^2}{\frac{1}{3} v_F \ell}$$

where L is half of the microbridge link 4 length, $V_F$ is the Fermi velocity, and $\ell$ is the mean free path for elastic scattering. Assuming, $2 \times 10^8$ cm/s for $v_F$ and 10 A for the mean free path (a worst case estimate), we get $\tau^* = 15$ ps. Using this to solve for Iqp in (2) we get Iqp $= 320$ $\mu$A. That give a current gain of 10. This quasiparticle input current $I_i$ would be input at the sum gap voltage, ~ 3 mV, so that a voltage gain of 5 is achieved.

These gains and speeds are quite respectable, and the device could serve as a general purpose logic or memory device. The device is noninverting and is expected to be latching, like the Josephson device, but it has high gain and a small size.

It will be apparent to one skilled in the art in the light of the principles set forth that alternative dimensions, materials and processes may be substituted and the performance varied.

In summary, what has been disclosed is a device where a quasiparticle injection current is introduced at an asymmetric location into a microbridge link that has the properties of a high critical current density for superconductivity and a high normal resistivity at a position that is fixed by the geometry of the structure so that reliable and reproducible high gain bandwidths are achieved.

## Claims

1. A superconductor switching device, wherein a signal impressed on a superconducting reduced cross-sectional area member (4) positioned between first (2) and second (3) larger cross-sectional area members operates to terminate the superconducting condition in the reduced cross-sectional area member (4) characterised by the reduced cross-sectional area member (4) having the properties of high superconductivity critical current density and high normal resistivity; means (5) for injecting a quasiparticle control signal into the reduced cross-sectional area member (4) at a location proximate to the first larger cross-sectional area member (2); and output current means connected to the second larger cross-sectional area member (3).

2. A device as claimed in claim 1, wherein the reduced cross-sectional area member (4) is on the same substrate surface that supports the first (2) and second (3) larger area members and said quasiparticle injection means is a conductor (5) positioned proximate to the first larger area member (2) and separated from the reduced cross-sectional area member (4) by a tunnel barrier (6).

3. A device as claimed in claim 1 wherein the quasiparticle injecting means (5) is a central conductor exposed at a bevelled surface having an insulating layer of a first thickness on a first side thereof and having an insulating layer of a larger thickness on the second side thereof, the conductor being oxidised at the exposure in said bevelled surface, and the reduced cross-sectional area member (4) being positioned on said bevelled surface.

4. A device as claimed in claim 2 or claim 3, wherein the reduced cross-section area includes a difference in thickness.

5. A device as claimed in claim 2 or claim 3, wherein the reduced cross-sectional area member (4) is NbN.

6. A device as claimed in claim 5, wherein the NbN reduced cross-sectional area member (4) is greater than or equal to 50 Angstroms thick.

7. A superconductor switching device wherein a signal impressed on a reduced cross-sectional area member (4) carrying a supercurrent positioned between first (2) and second (3) larger cross-sectional area member operates to terminate the superconducting condition in the reduced cross-sectional area member (4); a combination of means for nucleating a spot with normal resistance in an asymmetric location in the reduced cross-sectional area member (4); and means for propagating said spot into normal resistance throughout the reduced cross-sectional area member (4).

8. A device as claimed in claim 7, wherein the means for nucleating a spot with normal resistance is the combination of a high superconducting current density in the reduced cross-sectional area member (4) and quasiparticle current injection, and the means for propagating said spot is the combination of a high normal resistivity property of the reduced cross-sectional area member (4) and a high current in the reduced cross-sectional area member (4).

9. The device as claimed in claim 8, wherein the reduced cross-sectional area member (4) is on the same substrate surface that supports the first - (2) and second (3) larger area members and the quasiparticle injection means is a conductor (5) positioned proximate to the first larger area member (2) and separated from the reduced cross-sectional area member (4) by a tunnel barrier (6).

10. A device as claimed in claim 9 wherein the quasiparticle injecting means is a central conductor (5) exposed at a bevelled surface having an insulating layer of a first thickness on a first side thereof and having an insulating layer of a larger thickness on the second side thereof, the conductor (5) having a tunnel barrier (6), and the reduced cross-sectional area member (4) being positioned on the bevelled surface.

11. A device as claimed in claim 9 or claim 10 wherein said reduced cross-sectional area member (4) is NbN.

12. A signal translating superconductor device comprising an input to output superconductor current member, said member having a broad cross-sectional area (2, 3) at each extremity thereof joined by a reduced cross-sectional area switching control region (4), and a control electrode (5) in tunnelling relationship with the switching control region (4) at a point closer to one broad cross-sectional area member (2).

13. A device as claimed in claim 12, wherein the reduced superconductor current member (4) is positioned with the broad cross-sectional area members (2, 3) and the reduced cross-sectional area member (4) on a single surface with the reduced cross-sectional area member (4) having a smaller thickness and the control electrode (5) being positioned on an insulating layer on the reduced cross-sectional area member nearer to one broad cross-sectional area member (2) than the other cross-sectional area member (3).

14. A device as claimed in claim 13 wherein the control electrode (5) is a central conductor exposed at a bevelled surface having an insulating layer of a first thickness on a first side thereof and having an insulating layer of a larger thickness on the second side thereof, the conductor being covered by a tunnel barrier at the exposure in the bevelled surface, and the reduced cross-sectional area member (4) being positioned on the bevelled surface.

FIG.1A
PRIOR ART

FIG.1B

FIG.1C

FIG.1D

# FIG. 2
## PRIOR ART

# FIG. 3
## PRIOR ART

FIG. 4

FIG. 5

FIG. 6

FIG. 7

FIG. 8

FIG. 9

$I_I$ IN MILLIAMPS

VOLTAGE IN MILLIVOLTS

FIG. 10

$I_L$ IN MILLIAMPS

VOLTAGE IN MILLIVOLTS

FIG. 11

$I_L^{Cr}$
CRITICAL CURRENT
IN MILLIAMPS

$I_I$
IN MILLIAMPS

FIG. 12A

FIG. 12B

FIG. 12C

FIG. 12D

FIG. 12E

FIG. 12F

FIG. 12G

FIG. 12H

## FIG. 13A

## FIG. 13 B

## FIG. 13C

## FIG. 13D